(19) Europäisches Patentamt
European Patent Office
Office européen des brevets

(11) Veröffentlichungsnummer: **0 468 395 A1**

# (12) EUROPÄISCHE PATENTANMELDUNG

(21) Anmeldenummer: **91112230.7**

(51) Int. Cl.⁵: **C23C 16/18**

(22) Anmeldetag: **22.07.91**

(30) Priorität: **27.07.90 DE 4023882**
**06.07.91 DE 4122473**

(43) Veröffentlichungstag der Anmeldung:
**29.01.92 Patentblatt 92/05**

(84) Benannte Vertragsstaaten:
**AT BE CH DE DK ES FR GB IT LI NL SE**

(71) Anmelder: **Kali-Chemie Aktiengesellschaft**
**Postfach 220, Hans-Böckler-Allee 20**
**W-3000 Hannover 1(DE)**

(72) Erfinder: **Kruck, Thomas**
**Am Wachberg 9**
**W-5024 Erftstadt-Bliesheim(DE)**
Erfinder: **Heinen, Ralf**
**Am Kümpchenshof 13**
**W-3000 Köln 1(DE)**

(74) Vertreter: **Lauer, Dieter, Dr.**
**c/o Solvay Deutschland GmbH, Postfach 220**
**W-3000 Hannover(DE)**

## (54) Verfahren zur Abscheidung von Titan, Zirkonium oder Hafnium enthaltenden Schichten.

(57) Beschrieben wird ein Verfahren zur Abscheidung von Titan, Zirkonium oder Hafnium enthaltenden Schichten durch Zersetzung bestimmter Sandwich-Verbindungen des jeweiligen Metalls. Bevorzugt erfolgt die Zersetzung nach dem CVD-Verfahren.

EP 0 468 395 A1

Die Erfindung bezieht sich auf ein Verfahren zur Abscheidung einer Titan, Zirkonium oder Hafnium enthaltenden Schicht auf einem Substrat.

Es ist bekannt, Substrate durch Oberflächenbeschichtung so zu modifizieren, daß ihre Oberfläche bestimmte funktionale Eigenschaften aufweist. Beispielsweise kann man den elektrischen Strom leitende oder halbleitende Schichten, z.B. Leiterbahnen aufbringen. Weiterhin ist es bekannt, haftvermittelnde oder die Migration verhindernde Schichten auf Substraten aufzubringen.

Aufgabe der vorliegenden Erfindung ist es, ein Verfahren zur Abscheidung einer Titan, Zirkonium oder Hafnium enthaltenden Schicht auf einem Substrat anzugeben. Diese Aufgabe wird durch das erfindungsgemäße Verfahren gelöst.

Das erfindungsgemäße Verfahren zur Abscheidung einer Titan, Zirkonium oder Hafnium enthaltenden Schicht auf einem Substrat ist dadurch gekennzeichnet, daß man durch Zersetzung einer Verbindung der allgemeinen Formel (I)

$$(C_nR^1{}_uR^2{}_v)Mt(C_mR^3{}_wR^4{}_x) \qquad (I)$$

worin

n, m = 5, 6, 7, 8
u + v = n
w + x = m

und

$R^1$,$R^2$,$R^3$ und $R^4$ gleich oder verschieden sind und Wasserstoff oder Alkyl, C1-C3-Alkyl, insbesondere Methyl, bedeuten,
Mt Titan, Zirkonium oder Hafnium, vorzugsweise Titan bedeutet,
eine Titan, Zirkonium oder Hafnium enthaltende Schicht auf dem Substrat aufbringt. u, v, w und x entsprechen ganzen Zahlen zwischen 0 und n bzw. m.

Bei den Liganden der Verbindungen der Formel (I) handelt es sich um Kohlenstoffringe. Die Verbindungen liegen üblicherweise als sogenannte "Sandwich"-Verbindungen vor. In ihnen sind die Ring-Kohlenstoff-Atom der Kohlenstoffringe $C_nR^1{}_uR^2{}_v$ bzw. $C_mR^3{}_wR^4{}_x$ nach allgemeiner Ansicht gleichartig am Metallatom koordiniert. Solche Kohlenstoff-Ringe, die n oder m gleichartig an Metallatome koordinierte Kohlenstoffatome aufweisen, werden auch mit n-hapto bzw. $eta^n$ oder m-hapto bzw. $eta^m$ bezeichnet. Es wird allgemein angenommen, daß die Verbindungen der Formel (I) als (n-hapto-$C_nR^1{}_uR^2{}_v$)Mt(m-hapto-$C_mR^3{}_wR^4{}_x$) vorliegen.

Im erfindungsgemäßen Verfahren sind aber auch Verbindungen der Formel (I) einsetzbar, deren cyclische Liganden eine etwas abweichende Art der Koordination aufweisen. Für die Verbindung $(C_8H_8)Ti(C_8H_8)$ beispielsweise wird für möglich gehalten, daß sie in Form von (8-hapto-$C_8H_8$)Ti(8-hapto-$C_8H_8$) oder aber als (8-hapto-$C_8H_8$)Ti(4-hapto-$C_8H_8$) vorliegt. Selbstverständlich ist $(C_8H_8)$-$Ti(C_8H_8)$ ganz unabhängig von der Art der Koordination im erfindungsgemäßen Verfahren verwendbar.

Die vorliegende Erfindung wird im Hinblick auf die bevorzugte Ausführungsform, nämlich die Erzeugung Titan enthaltender Schichten, weiter erläutert.

Bevorzugt wendet man Verbindungen an, in welchen $R^1$,$R^2$,$R^3$ und $R^4$ Wasserstoff bedeuten oder in welchen $R^1$ und $R^2$ Methyl und $R^3$ und $R^4$ Wasserstoff bedeuten.

Bevorzugt bedeutet n und m jeweils 8, oder aber es bedeutet n = 5 und m = 7, oder es bedeutet n = 5 und m = 8, oder es bedeutet n und m jeweils 6. Besonders gut sind Verbindungen geeignet, in welchen n = 5 und m = 7 bedeutet.

Gut verwendbar sind beispielsweise $(C_8H_8)_2Ti$; $(c_5H_5)Ti(C_8H_8)$, $(C_5Me_5)Ti(C_8H_8)$; $(C_5H_5)Ti(C_7H_7)$; $(C_5Me_5)Ti(C_7H_7)$ oder $(C_6H_6)_2Ti$.

Hervorragend geeignet ist (5-hapto-$C_5H_5$)Ti(7-hapto-$C_7H_7$).

Zur Abscheidung einer Titan enthaltenden Schicht kann der Fachmann die Abscheidung aus der kondensierten Phase oder aus der Gas- bzw. Dampfphase vornehmen. Für den Fachmann ist dabei selbstverständlich, daß er nicht nur eine bestimmte Verbindung der allgemeinen Formel (I), sondern auch Gemische solcher Verbindungen einsetzen kann.

Zur Abscheidung aus der kondensierten Phase bringe der Fachmann die Verbindung der Formel (I) ohne Lösungsmittel oder vorzugsweise in einem Lösungsmittel gelöst auf dem Substrat auf und zersetzt die Verbindung. Als Lösungsmittel können polare oder unpolare, aprotische organische Lösungsmittel, die gewünschtenfalls koordinierende Eigenschaften aufweisen können, verwendet werden. Geeignet sind beispielsweise aliphatische Kohlenwasserstoffe wie Pentan oder Petrolbenzin, aromatische Kohlenwasserstoffe wie Benzol oder Toluol oder Ether wie Tetrahydrofuran.

Um die jeweilige Ausgangsverbindung auf dem Substrat aufzubringen, kann man sich bekannter Methoden bedienen beispielsweise kann man das Substrat in die Verbindung oder eine entsprechende Lösung eintauchen, man kann die Ausgangsverbindung oder eine entsprechende Lösung auf dem Substrat aufstreichen oder, bevorzugt, die Verbindung oder eine entsprechende Lösung auf das Substrat aufsprühen.

Mittels dieser Ausführungsform des erfindungsgemäßen Verfahrens, nämlich dem Aufbringen der Ausgangsverbindung (bzw. einem entsprechenden Gemisch von Ausgangsverbindungen) aus der kondensierten Phase, gelingt es, auch große Flächen sehr schnell zu beschichten.

Dann erfolgt die Zersetzung der auf dem Substrat aufgebrachten Ausgangsverbindung zur Abscheidung einer Titan enthaltenden Schicht, gewünschtenfalls unter vermindertem Druck. Zweckmäßig bewirkt man die Zersetzung thermisch.

Dies kann durch Einbringen des mit der Ausgangsverbindung beschichteten Substrats in eine entsprechend beheizte Kammer, durch Heizen des Substrats vor, während und/oder nach dem Aufbringen der Ausgangsverbindung auf den angegebenen Temperaturbereich erfolgen.

Die thermische Zersetzung kann auch strahlungsinduziert bewirkt werden, beispielsweise durch einen Laser, der im UV-Bereich, im Infrarot-Bereich oder im Bereich des sichtbaren Lichts arbeitet und den Träger aufheizt.

Gewünschtenfalls kann die Zersetzung auch durch Photolyse erfolgen. Die photolytische Zersetzung kann aber auch durch einen bei der entsprechenden Wellenlänge betriebenen Laser oder einer UV-Lampe bewirkt werden.

Die Zersetzung kann man auch plasmainduziert durchführen. Hierzu eignen sich die verschiedenen bekannten Verfahren.

Beispielsweise kann man ein thermisches Plasmaverfahren, z.B. Lichtbogenplasma oder Plasmajet, anwenden. Der Druck liegt dann üblicherweise zwischen 10 Torr und Normaldruck.

Gut geeignet sind insbesondere auch Niederdruckplasmaverfahren, z.B. Gleichstromplasmaverfahren, Glimmentladungsplasmaverfahren und Wechselstromplasmaverfahren, z.B. Niederfrequenz-, Mittelfrequenz-, Hochfrequenzplasmaverfahren und Mikrowellenplasmaverfahren. Man arbeitet üblicherweise bei Drucken unterhalb 10 mbar, beispielsweise zwischen $10^{-2}$ und 1 mbar.

Die plasmainduzierte Zersetzung erfolgt in bekannten Plasmareaktoren. Verwendbar sind beispielsweise Rohr-, Tunnel-, Parallelplatten-und Coronaentladungsreaktoren. Da die Zersetzung im Plasma gewünschtenfalls bei niedrigen Temperaturen durchgeführt werden kann, ist die Zersetzung im Plasma gut geeignet zur Beschichtung von Substraten mit ver hältnismäßig geringerer Thermostabilität, beispielsweise für Beschichtung von Kunststoffen.

Der Fachmann kann durch Zusatz eines Reaktivgases die Form, in welcher das Titan in der Schicht vorliegt, beeinflussen. Dies, sowie die Möglichkeit der gleichzeitigen Abscheidung anderer Metalle oder der sukzessiven Abscheidung weiterer, insbesondere weiterer Schichten mit anderer Zusammensetzung, wird noch erläutert.

Eine andere Ausführungsform des erfindungsgemäßen Verfahrens betrifft die Zersetzung der Ausgangsverbindung in der Gas- bzw. Dampfphase. Diese Ausführungsform ermöglicht die Abscheidung besonders gut haftender, gleichmäßiger, dünner Schichten.

Der Druck in der Dampfphase bzw. Gasphase kann mehr oder weniger hoch sein. Man kann beispielsweise bei einem Druck arbeiten, der dem Dampfdruck der verwendeten Ausgangsverbindung bei der Arbeitstemperatur entspricht. Der Gesamtdruck kann aber auch höher sein, bis hin zum Normaldruck. Zweckmäßig arbeitet man bei vermindertem Druck, beispielsweise bei $10^{-2}$ bis 10 mbar, vorzugsweise bei 0,1 bis 1 mbar.

Die Zersetzung der Ausgangsverbindung in der Dampfphase oder Gasphase führt man zweckmäßig nach Art eines CVD(Chemical-Vapour-Deposition)-Verfahrens durch.

Die prinzipielle Vorgehensweise zur Beschichtung von Substraten unter Anwendung von CVD-Verfahren sowie geeigneter Apparaturen dafür sind bekannt. Die EP-A 297 348 (die sich allerdings mit völlig anderen Beschichtungen befaßt als die vorliegende Erfindung, nämlich mit der Abscheidung von Kupfer, Silber oder Gold enthaltenden Schichten) gibt dem Fachmann ausführliche Hinweise, wie ein CVD-Verfahren durchzuführen ist und welche Apparaturen verwendbar sind.

Die Zersetzung aus der Gas- bzw. Dampfphase wird zweckmäßig in einer druckfesten, evakuierbaren Vorrichtung durchgeführt. In diese Vorrichtung wird das zu beschichtende Substrat eingebracht. Bei vermindertem Druck wird eine Atmosphäre erzeugt, welche die Titan enthaltende Ausgangsverbindung enthält. Neben der unter diesen Bedingungen dampfförmig oder gasförmig vorliegenden Ausgangsverbindung kann gewünschtenfalls Inertgas oder Reaktivgas im Gasraum der Vorrichtung vorhanden sein.

In einer Variante wird die Ausgangsverbindung zusammen mit dem zu beschichtenden Substrat in die Vorrichtung eingebracht.

In einer alternativen, bevorzugten Variante wird zunächst nur das Substrat in die druckfeste Vorrichtung eingebracht und die bereits gas- bzw. dampfförmig vorliegende Ausgangsverbindung über eine besondere Leitung kontinuierlich oder diskontinuierlich in die Vorrichtung eingebracht. Auch hier kann ein Trägergas angewendet werden.

Die Überführung der Ausgangsverbindung in die Gas- bzw. Dampfphase kann man durch Erwärmen und gewünschtenfalls durch Zusatz eines Trägergases unterstützen.

Die Zersetzung erfolgt nach bekannten Methoden thermisch, plasmainduziert und/oder photolytisch.

Die thermische Zersetzung aus der Gas- bzw. Dampfphase führt man üblicherweise so durch, daß die Wände der Vorrichtung kalt gehalten werden und das Substrat auf eine Temperatur erhitzt wird, bei welcher sich die gewünschte Titan enthaltende Schicht auf dem Substrat abscheidet. Der Fachmann kann durch einfache orientierende Versuche für die jeweils eingesetzte Verbindung die notwendige Mindesttemperatur leicht bestimmen. Üblicherweise liegt die Temperatur, auf welche das Substrat erhitzt wird, oberhalb von etwa 120 °C.

Die Beheizung der Substrate kann in üblicher Weise erfolgen, beispielsweise durch Widerstandsheizung, Induktionsheizung, elektrische Heizeinrichtung wie Heizwendeln oder ähnlichem. Die Aufheizung der Substrate kann auch durch Strahlungsenergie induziert werden. Hierfür eignet sich insbesondere Laserstrahlungsenergie. Beispielsweise kann man Laser verwenden, die im Bereich des sichtbaren Lichtes, im UV-Bereich oder im IR-Bereich arbeiten. Laser besitzen den Vorteil, daß man sie mehr oder weniger fokussieren kann und daher gezielt bestimmte, begrenzte Bereiche oder Punkte des Substrats erhitzen kann.

Da das thermische CVD-Verfahren üblicherweise bei Unterdruck durchgeführt wird, ist es für den Fachmann selbstverständlich, druckfeste Apparaturen vorzusehen, wie sie in der Vakuumtechnik verwendet werden. Die Apparaturen weisen zweckmäßigerweise beheizbare Gasleitungen für die metallorganische Verbindung oder das Inertgas, absperrbare Öffnungen für Gasein- und auslaß auf, gegebenenfalls Öffnungen zur Zuführung eines Träger- oder Reaktivgases, Temperaturmeßeinrichtungen, gewünschtenfalls eine Öffnung für die Zuführung der metallorganischen Verbindung, eine Einrichtung für die Aufheizung des Substrats, eine zur Erzeugung des gewünschten Unterdruckes geeignete Pumpe etc. Für den Fall der Durchführung eines durch Strahlungsenergie induzierten CVD-Verfahrens muß auch noch eine Strahlungsquelle vorhanden sein, die Strahlung im Bereich des sichtbaren Lichtes, des Infrarot- oder Ultraviolett-Bereiches abgibt. Besonders geeignet sind entsprechende Laser-Strahlungsenergiequellen. Mittels der Strahlungsenergie kann das Substrat aufgeheizt werden.

Eine sehr einfache, zweckmäßige Vorrichtung zur Verfahrensdurchführung ist in Fig. 1 wiedergegeben.

Sie umfaßt ein mit einer Inertglaszuleitung 1 über ein absperrbares Ventil 2 verbundenes Glasrohr 3, das konzentrisch in einem röhrenförmig aufgebauten Heizofen 4 angeordnet ist, welcher zwei Heizzonen 5 und 6 aufweist ("Zweizonenröhrenofen"). Die andere Seite des Rohres ist über eine Kühlfalle 7 mit einer Vakuumpumpe 8 verbunden.

In die erste Heizzone, die auf der Seite der Inertglaszuleitung liegt, wird die Ausgangsverbindung eingebracht. In die zweite Heizzone, die auf der Seite der Vakuumpumpe liegt, bringt man das Substrat ein.

Die plasmainduzierte Zersetzung führt man in einer schon vorstehend beschriebenen Apparatur durch.

Ohne daß hier eine Erklärung für die Bildung von Schichten durch Zersetzung der Titanverbindungen gegeben werden soll, wird angenommen, daß Gase bzw. Dämpfe der Titanverbindung auf das Substrat gelangen und dort unter Bildung der Titan enthaltenden Schichten zersetzt werden. Die Dicke der Schicht ist im wesentlichen abhängig von der Zeitdauer, während welcher die Abscheidung durchgeführt wird, vom Partialdruck der metallorganischen Verbindung und von der Abscheidungstemperatur. Es lassen sich mehr oder weniger dünne Schichten erzeugen, beispielsweise Schichten mit einer Dicke von bis zu 20 Mikrometer, beispielsweise zwischen 100 Angström und 20 Mikrometer. Je nach gewünschter Schichtdicke kann der Fachmann durch orientierende Versuche die zur Erzeugung einer Titan enthaltenden Schicht bestimmter Dicke notwendige Zeitdauer und Abscheidungstemperatur bestimmen.

Wie schon gesagt, kann die Zersetzung auch photolytisch bewirkt werden, beispielsweise indem man einen mit geeigneter Wellenlänge arbeitenden Laser verwendet oder mittels einer UV-Lampe.

Der das Substrat umgebende Gasraum enthält die gas- bzw. dampfförmig vorliegende Ausgangsverbindung. Es wurde bereits weiter oben erwähnt, daß weiterhin ein Inertgas oder ein Reaktivgas in der Gasatmosphäre enthalten sein kann. Abhängig von der Art der Durchführung werden ganz unterschiedliche Titan enthaltende Schichten abgeschieden.

Zersetzt man die Ausgangsverbindung ohne Zusatz eines Inertgases oder eines Reaktivgases, so scheiden sich bei thermischer Zersetzung, insbesondere bei der Durchführung als CVD-Verfahren, Schichten ab, die Titan im wesentlichen in metallischer Form enthalten.

Arbeitet man ohne Zusatz eines Inertgases oder eines Reaktivgases und bewirkt die Zersetzung plasmainduziert in einem CVD-Verfahren, so scheiden sich Schichten ab, die das Titan im wesentlichen in Form von Titancarbid enthalten.

Schichten, die bei thermischer Zersetzung insbesondere in einem thermischen CVD-Verfahren Titan im wesentlichen in metallischer Form enthalten bzw. Schichten, welche insbesondere in einem plasmainduzierten CVD-Verfahren das Titan im wesentlichen in Form von Titancarbid enthalten, werden auch abgeschieden, wenn man in Anwesenheit eines Inertgases, beispielsweise in Anwesenheit von Edelgasen wie Argon arbeitet.

In einer anderen Ausführungsform führt man die Zersetzung in einer Reaktivgasatmosphäre durch. Eine solche reaktive Gasatmosphäre kann natürlich zusätzlich Inertgas enthalten, beispielsweise Edelgase wie Argon.

In einer Variante arbeitet man in einer nitridierenden Reaktivgasatmosphäre. Man führt die Zersetzung insbesondere nach Art eines thermischen oder plasmainduzierten CVD-Verfahrens durch. Die Zersetzung der Titan enthaltenden Ausgangsverbindung in einer Reaktivgasatmosphäre, welche Ammoniak, Stickstoff oder ähnliche N-haltige Zusätze enthält, ergibt Titan enthaltende Schichten, welche das Titan im wesentlichen in Form von Titannitrid enthalten.

In einer anderen Variante führt man die Zersetzung insbesonder nach Art eines thermischen oder plasmainduzierten CVD-Verfahrens durch. Durch Zersetzung der Titan enthaltenden Ausgangsverbindung in einer Reaktivgasatmosphäre, die N-haltige Gaszusätze und C-haltige Gaszusätze, z.B. Alkane, enthält, bilden sich Schichten, die das Titan im wesentlichen in Form von Titancarbonitrid, $TiC_xN_y$, enthalten. In den Carbonitriden beträgt die Summe von x und y etwa 1 bis 1,1. Diese Zusammensetzungen können also auch nichtstöchiometrisch sein.

In einer anderen Variante führt man die Zersetzung ebenfalls insbesondere nach Art eines thermischen oder plasmainduzierten CVD-Verfahrens durch und zersetzt die Titan enthaltende Ausgangsverbindung in einer hydrolysierenden und/oder oxidierenden Reaktivgasatmosphäre durch. Zweckmäßig enthält diese Reaktivgasatmosphäre Wasser und/oder Sauerstoff, $N_2O$ oder Ozon. Bei der Zersetzung bilden sich Schichten, die das Titan im wesentlichen in Form von Titandioxid enthalten.

Im erfindungsgemäßen Verfahren kann man im Prinzip beliebige Substrate beschichten, auf denen eine Beschichtung wünschenswert ist. Beispielsweise kann man anorganische Materialien, wie Metalle oder Metallegierungen z.B. Stahl, Halbleiter, Silicium, Isolatoren, Keramik, oder organische Polymere, z.B. Polyphenylensulfid, Polyimide oder Polymethylmethacrylat, als Substrate verwenden.

Die Abscheidung von Schichten, die das Titan im wesentlichen in Form von metallischen Titan enthalten, ermöglicht beispielsweise unter Abdekkung bestimmter nicht zu beschichtender Bereiche nach an sich bekannten Strukturierungsverfahren die Erzeugung für den elektrischen Strom leitfähiger Leiterbahnen auf nichtleitenden Substraten, beispielsweise auf Keramik oder organischen Polymeren. Auf bestimmten Substraten beobachtet man unter bestimmten Voraussetzungen an sich bekannte Diffusionsphänomene. Metallisches Titan, aufgebracht auf Siliciumsubstraten, diffundiert bei Aufheizung der Substrate auf hohe Temperatur, beispielsweise 700 °C in diese Siliciumsubstrate ein und bildet Schichten, die mehr oder weniger Titan enthalten und im Grenzfall Titansilicid darstellen. Solche Titansilicide sind funktionelle Schichten in der Mikroelektronik.

Schichten, die Titan im wesentlichen in Form von Titancarbid, Titannitrid und/oder Carbonitrid enthalten, wirken verschleißmindernd und haftverbessernd. Beispielsweise kann man Metalle oder Metallegierungen beschichten, insbesondere solche, die zur Herstellung von Werkzeugen oder Maschinenbauteilen verwendet werden. Weiterhin wirken Titannitrid enthaltenden Schichten als Diffusionssperre, die beispielsweise in der Halbleitertechnik benötigt werden.

Titandioxid enthaltende Schichten werden beispielsweise in der optischen Industrie benötigt oder dienen dazu, Kunststoffe kratzfest auszurüsten.

Das erfindungsgemäße Verfahren bietet dem Fachmann aber noch weitere Möglichkeiten. Es eignet sich beispielsweise auch zur Abscheidung von Schichten, welche neben dem Titan ein oder mehrere andere Metalle enthalten. Diese Ausführungsform des erfindungsgemäßen Verfahrens ist dadurch gekennzeichnet, daß man zur Abscheidung von solchen Schichten eine oder mehrere Verbindungen anderer Metalle und eine Verbindung der allgemeinen Formel (I) gleichzeitig zersetzt. Es bilden sich dann Schichten, die Titan und ein oder mehrere andere Metalle in homogener Mischung enthalten. Auch bei dieser Ausführungsform kann man in inerter oder Reaktivgasatmosphäre arbeiten. Beispielsweise kann man als Verbindung eines weiteren Metalles ein β-Diketonat von Blei verwenden und in oxidierender Atmosphäre Bleititanat enthaltende Schichten abscheiden. Solche Schichten weisen dielektrische Eigenschaften auf.

Weiterhin kann der Fachmann mehrere unterschiedliche Schichten sukzessive nacheinander auf Substraten aufbringen, wobei mindestens eine Schicht gemäß dem erfindungsgemäßen Verfahren erzeugt wird.

Beispielsweise kann man auf einem Substrat nach dem erfindungsgemäßen Verfahren zunächst eine Titannitrid enthaltende Schicht abscheiden, welche als Diffusionssperre wirkt und zudem die Haftung weiterer abzuscheidender Schichten verbessert. Dann kann man nach dem erfindungsgemäßen Verfahren durch geeignete Abdeckung bestimmter nicht zu beschichtender Bereiche nach an sich bekannten Strukturierungsverfahren Leiterbahnen erzeugen, indem man metallisches Titan enthaltende Schichten gemäß dem erfindungsgemäßen Verfahren abscheidet. Gewünschtenfalls kann man dann erneut eine Titannitrid enthaltende Schicht nach dem erfindungsgemäßen Verfahren als Schutzschicht abscheiden.

Natürlich kann man vor oder nach Abscheidung von Titan enthaltenden Schichten gemäß dem erfindungsgemäßen Verfahren auch bereits bekannte Abscheidungsverfahren durchführen. Beispielsweise kann man auf Substrate nach dem erfindungsgemäßen Verfahren eine Titannitrid enthaltende

Schicht als Diffusionssperre und zur Haftverbesserung erzeugen. Dann kann man gemäß dem aus der EP-A 297 348 bekannten Verfahren unter geeigneter Abdeckung bestimmter, nicht zu beschichtender Bereiche nach an sich bekannten Strukturierungsverfahren Leiterbahnen erzeugen, indem man durch Zersetzung von Trialkylphosphan-(cyclopentadienyl)-Kupfer(I)-Komplexen in einem thermischen CVD-Verfahren bei stark vermindertem Druck Kupfer abscheidet.

Die im erfindungsgemäßen Verfahren verwendeten Verbindungen der allgemeinen Formel (I) und ihre Herstellung sind bereits bekannt.

Zur Herstellung von Verbindungen der allgemeinen Formel (I), in welchen n gleich 5 ist und m gleich 7 oder 8 bedeutet, kann man von Verbindungen der allgemeinen Formel $(C_5R^1{}_uR^2{}_v)TiCl_3$ (II) ausgehen. Die Herstellung auch dieser Zwischenverbindungen ist bekannt und wird beispielsweise im "Gmelin Handbuch der anorganischen Chemie, Ergänzungswerk zur 8. Auflage, Band 40, Titanorganische Verbindungen, Teil 1, Seite 136 bis 142" beschrieben. Beispielsweise kann man Titantetrachlorid mit der entsprechende Cyclopentadienyl-Lithium-, Magnesium-oder Natriumverbindung mit oder ohne Lösungsmittel umsetzen und die Verbindung der Formel (II) isolieren.

So gelingt beispielsweise die Herstellung von $(C_5H_5)TiCl_3$ durch Umsetzung von Titantetrachlorid und Bis(cyclopentadienyl)magnesium in Xylol mit 78 %iger Ausbeute.

Die Herstellung von $(C_5H_4Me)TiCl_3$, worin "Me" Methyl bedeutet, erfolgt durch Umsetzung von Titantetrachlorid mit Methylcyclopentadienylnatrium in siedendem Xylol.

Die Herstellung von $(C_5Me_5)TiCl_3$ erfolgt durch Umsetzung von Pentamethylcyclopentadienyllithium in Benzol/Hexan bei Raumtemperatur.

In ähnlicher Weise lassen sich die entsprechenden Zirkoniumverbindungen herstellen, Cyclopentadienylzirkoniumtrichlorid beispielsweise aus Cyclopentadienylmagnesiumchlorid oder Bis-(cyclopentadienyl)magnesium und Zirkontetrachlorid, siehe auch Gmelins Handbuch der anorganischen Chemie, Ergänzungswerk zur 8. Auflage, Zirkoniumorganische Verbindungen, Band 10 (1973), Seite 15 und 16.

Entsprechende Hafniumverbindungen können beispielsweise durch Chlorierung von entsprechenden Bis(cyclopentadienyl)Hafniumdichlorid-Verbindungen hergestellt werden.

Die entsprechend hergestellten Organo-Titan-, Zirkonium- oder Hafniumtrichlorid-Verbindungen werden dann zu den gewünschten Verbindungen der allgemeinen Formel (I) weiter umgesetzt.

Die Umsetzung von $(C_5H_5)TiCl_3$ zu $(C_5H_5)Ti(C_7H_7)$ mittels Cycloheptatrien in Anwesenheit einer Grignard-Verbindung, nämlich $i\text{-}C_3H_7MgBr$ in Ether, wird bei H.O.van Oven, H.H. De Liefde Meijer in J. Organomet. Chem. 27 (1970), Seiten 159 bis 163 beschrieben.

Die Umsetzung von $(C_5H_5)TiCl_3$ zu $(C_5H_5)Ti(C_7H_7)$ mittels Mg und Cycloheptatrien in THF oder zu $(C_5H_5)Ti(C_8H_8)$ mittels $K_2C_8H_8$ in THF wird von L.B. Kool, M.D. Rausch und R.D. Rogers in J. Organomet. Chem. 297 (1985), Seiten 289 - 299 beschrieben.

Die Herstellung von $(C_5Me_5)Ti(C_7H_7)$,$(C_5Me_5)Zr(C_7H_7)$, $(C_5Me_5)Hf(C_7H_7)$ sowie $(C_5Me_5)Ti(C_8H_8)$ und $(C_5Me_5)Zr(C_8H_8)$ wird von J. Blenkers, P. Bruin und J.H. Teuben in J. Organomet. Chem. 297 (1985), Seiten 61 bis 67 beschrieben.

Nach diesen Autoren stellt man die Verbindungen durch Umsetzung der betreffenden Organometall-Trichlorid-Verbindung mit Cycloheptatrien bzw. Cyclooctatetraen mittels Mg-Spänen in Ether her.

Man kann auch substituiertes Cycloheptatrien einsetzen. Man erhält dann metallorganische Verbindungen, in welchen entsprechend substituierte Cycloheptatrienyl-Gruppen vorhanden sind. Die Herstellung solcher Verbindungen ist beispielsweise in "Gmelins Handbuch der anorganischen Chemie, 8. Auflage (1984), Organo-Titan-Verbindungen Teil 4, Seite 82 bis 87" beschrieben.

Die Herstellung von Verbindungen der allgemeinen Formel (I), in welchen n und m 8 bedeutet, wird beispielsweise von H. Breil und G. Wilke in Angew. Chem. 78 (1966) Seite 942 beschrieben. Die Herstellung gelingt durch Umsetzung von Tetrabutoxytitan mit Cyclooctatetraen bei 80 °C mit Triethylaluminium.

Die Herstellung von Verbindungen der allgemeinen Formel (I), bei denen n und m jeweils 6 bedeuten, kann nach dem von P.N. Hawker, E.P. Kündig und P. Timms in J.C.S. Chem. Comm. 1978, Seiten 730 und 731 beschriebenen Verfahren durchgeführt werden. Bei jenem Verfahren werden Kaliumatome bei -100 °C in eine gerührte Lösung eines Titanhalogenids, z.B. $TiCl_3$ und des gewünschten Arens, z.B. Toluol oder Mesitylen, in Tetrahydrofuran kondensiert. Das Produkt wird dann in üblicher Weise aus der Lösung isoliert und kristallisiert.

Eine andere Möglichkeit zur Herstellung von Verbindungen der allgemeinen Formel (I), bei denen n und m jeweils 6 bedeuten, beschreiben F.W.S. Benfield, M.H. Green, J.S. Ogden und D. Young in J.C.S. Chem. Comm. 1973, Seiten 866 und 867. Bei jenem Verfahren werden Titandampf und Benzoldampf im Vakuum zum gewünschten $(C_6H_6)_2Ti$ kokondensiert.

Die folgenden Beispiele sollen das erfindungsgemäße Verfahren weiter erläutern, ohne es in seinem Umfang einzuschränken.

Beispiel 1:

Herstellung von $(C_5H_5)Ti(C_7H_7)$

Die Herstellung erfolgte analog der Arbeitsvorschrift von H.O. van Oven und H.J. de Liefde Meijer in J. Organomet. Chem. 23 (1970), Seiten 159 und 160.

8,08 g $C_5H_5TiCl_3$ und 12,4 g $C_7H_8$ wurden unter Stickstoffatmosphäre in getrocknetem, sauerstofffreiem Ether gelöst. Die Lösung wurde auf -78 °C gekühlt und 140 ml einer etwa 0,8-molaren Lösung von i-$C_3H_7MgBr$ in Ether während einer Zeitdauer von etwa 4 Stunden zugegeben. Nach beendeter Zugabe wurde noch etwa 1,5 Stunden bei -78 °C weitergerührt. Man ließ die Reaktionsmischung dann auf Umgebungstemperatur kommen und rührte danach noch etwa 12 Stunden lang weiter. Das Lösungsmittel wurde dann im Vakuum abgetrennt, der verbleibende Rückstand zweimal mit jeweils 100 ml Pentan gewaschen. Aus dem verbleibenden Rückstand wurden dann bei etwa 125 °C und einem Druck von etwa 1 mm blaue Kristalle heraussublimiert. Ausbeute: etwa 2.8 g.

Das Beispiel 1 wurde zur Gewinnung größerer Mengen der Titan-Verbindung mehrfach wiederholt.

2. Anwendung von $(C_5H_5)Ti(C_7H_7)$ zur Herstellung Titan enthaltender Schichten

2.1. Verwendete Apparatur

Verwendet wurde eine entsprechend Fig. 1 aufgebaute Vorrichtung.

Ein Quarzglasrohr war konzentrisch in einen 2-Zonenröhrenofen eingebracht. Die eine Seite des Quarzrohres war absperrbar mit einer Inertgasleitung verbunden, die andere Seite mit einer Vakuumpumpe. Zwischen Quarzrohr und Vakuumpumpe befand sich eine tiefkühlbare Falle zur Abtrennung flüchtiger Bestandteile aus dem abgepumpten Gasstrom.

Die zu verdampfende metallorganische Verbindung wurde in einem Porzellanschiffchen in das Glasrohr in der 1. Heizzone des 2-Zonenröhrenofens positioniert. Das Substrat wurde in die 2. Heizzone eingebracht. In einem Versuch diente die Glaswand als Substrat.

2.2. Versuchsdurchführung

2.2.1. Anwendung von Silicium als Substrat

Als Substrat wurden Siliciumscheiben verwendet. Die gemäß Beispiel 1 hergestellte Titanverbindung wurde in die 1. Heizzone eingebracht.

Das Siliciumsubstrat wurde in der 2. Heizzone auf eine Temperatur von etwa 400 °C gebracht. Der Druck betrug etwa 0,03 mbar. Die Ausgangsverbindung wurde in der 1. Heizzone auf 120 °C erwärmt. Der dabei sich bildende Dampf der Ausgangsverbindung strömte über das Substrat und zersetzte sich unter Abscheidung einer titanhaltigen Schicht. Ein Trägergas wurde nicht verwendet.

Nach etwa 10 Minuten wurde die Abscheidung beendet und über die bis dahin abgesperrte Inertgasleitung das Quarzrohr mit gereinigtem Stickstoff auf Normaldruck gebracht. Die beschichteten Substrate wurden aus dem Quarzrohr entnommen. Die Analyse ergab, daß die Scheiben mit Titan beschichtet waren. Die Schicht enthielt weniger als 1 Gew.-% Kohlenstoff.

2.2.2. Anwendung von Stahl als Substrat

Beispiel 2.2.1. wurde wiederholt, wobei diesmal jedoch Stahlscheiben als Substrat verwendet wurden. Die Abscheidungsbedingungen und das Ergebnis entsprachen demjenigen von Beispiel 2.2.1..

2.2.3. Anwendung von Glas als Substrat

Beispiel 2.2.1. wurde wiederholt. Diesmal wurde jedoch kein Substrat in die 2. Heizzone eingebracht, sondern die Glaswand in dieser Zone diente als Substrat. Die übrige Durchführung entsprach dem Beispiel 2.2.1.. Nach beendeter Abscheidung wurde festgestellt, daß sich auf dem Quarzglasrohr eine Schicht von Titan abgeschieden hatte.

**Patentansprüche**

**1.** Verfahren zur Abscheidung einer Titan, Zirkonium oder Hafnium enthaltenden Schicht auf einem Substrat, dadurch gekennzeichnet, daß man durch Zersetzung einer Verbindung der allgemeinen Formel (I)

$$(C_nR^1{}_uR^2{}_v)Mt(C_mR^3{}_wR^4{}_x) \qquad (I)$$

worin

n, m = 5, 6, 7, 8

u + v = n

w + x = m

und

$R^1$,$R^2$,$R^3$ und $R^4$ gleich oder verschieden sind und Wasserstoff, Alkyl insbesondere Methyl bedeuten,

Mt Titan, Zirkonium oder Hafnium, vorzugsweise Titan bedeutet,

eine Titan, Zirkonium oder Hafnium enthaltende Schicht auf dem Substrat aufbringt.

**2.** Verfahren nach Anspruch 1, dadurch gekennzeichnet, daß entweder n und m jeweils 8 bedeuten, daß $n=5$ und $m=8$, daß $n=5$ und $m=7$ oder daß n und m jeweils 6 bedeutet.

**3.** Verfahren nach Anspruch 1 oder 2, dadurch gekennzeichnet, daß $n=5$ und $m=7$ bedeutet.

**4.** Verfahren nach einem der vorhergehenden Ansprüche, dadurch gekennzeichnet, daß $R^1$,$R^2$,$R^3$ und $R^4$ Wasserstoff bedeuten oder daß $R^1$ und $R^2$ Methyl und $R^3$ und $R^4$ Wasserstoff bedeuten.

**5.** Verfahren nach einem der Ansprüche 1 bis 4, dadurch gekennzeichnet, daß man die Verbindung der allgemeinen Formel (I) in der Flüssigphase zersetzt.

**6.** Verfahren nach Anspruch 5, dadurch gekennzeichnet, daß man die Verbindung der allgemeinen Formel (I) auf das Substrat aufbringt, vorzugsweise aufsprüht, und zersetzt.

**7.** Verfahren nach einem der Ansprüche 1 bis 4, dadurch gekennzeichnet, daß man die Verbindung der allgemeinen Formel (I) in der Gasbzw. Dampfphase zersetzt.

**8.** Verfahren nach Anspruch 7, dadurch gekennzeichnet, daß man die Verbindung der allgemeinen Formel (I) unter vermindertem Druck, gewünschtenfalls unter Anwendung eines Trägergases, in die Dampfphase überführt und bei vermindertem Druck zersetzt.

**9.** Verfahren nach einem der vorhergehenden Ansprüche, dadurch gekennzeichnet, daß man die Zersetzung thermisch bewirkt.

**10.** Verfahren nach Anspruch 9, dadurch gekennzeichnet, daß man die Zersetzung der Verbindung der allgemeinen Formel (I) thermisch durch Aufheizen des Substrats auf Temperaturen oberhalb von etwa 120 °C bewirkt.

**11.** Verfahren nach einem der vorhergehenden Ansprüche, dadurch gekennzeichnet, daß man die Zersetzung mittels Strahlungsenergie, insbesondere Laserstrahlungsenergie bewirkt.

**12.** Verfahren nach einem der Ansprüche 1 bis 10, dadurch gekennzeichnet, daß man die Zersetzung plasmainduziert bewirkt.

**13.** Verfahren nach einem der vorhergehenden Ansprüche, dadurch gekennzeichnet, daß man zur Abscheidung von Titan, Zirkonium oder Hafnium enthaltenden Schichten, welche Titan, Zirkonium oder Hafnium im wesentlichen in metallischer Form enthalten, die Zersetzung in einer gegenüber dem gebildeten Metall und der verwendeten Verbindung der allgemeinen Formel (I) inerten ggf. Wasserstoff enthaltenden Gasatmosphäre durchführt.

**14.** Verfahren nach einem der Ansprüche 1 bis 12, dadurch gekennzeichnet, daß man zur Abscheidung von Titan, Zirkonium oder Hafnium enthaltenden Schichten, welche Titan, Zirkonium oder Hafnium in Form der Nitride, Carbonitride oder Oxide enthalten, die Zersetzung in Anwesenheit einer reaktiven Atmosphäre, vorzugsweise einer nitridierenden, oxidierenden, hydrolysierenden oder carbonisierenden Gasatmosphäre durchführt.

**15.** Verfahren nach einem der vorhergehenden Ansprüche, dadurch gekennzeichnet, daß man zur Abscheidung von Titan, Zirkonium oder Hafnium enthaltenden Schichten, welche weiterhin ein anderes Metall oder mehrere andere Metalle enthalten, eine oder mehrere Verbindungen solcher anderen Metalle sowie eine Verbindung der allgemeinen Formel (I) gleichzeitig zersetzt.

**16.** Verfahren nach einem der vorhergehenden Ansprüche, dadurch gekennzeichnet, daß man mehrere unterschiedliche Schichten nacheinander abscheidet.

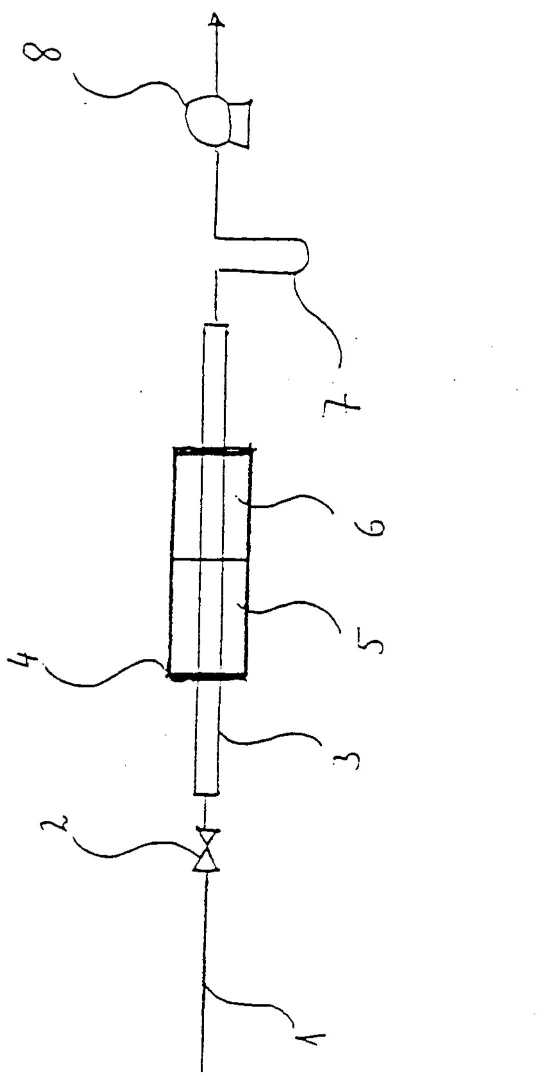


Fig. 1

Europäisches Patentamt

# EUROPÄISCHER RECHERCHENBERICHT

Nummer der Anmeldung

**EP 91 11 2230**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | WO-A-8 804 830 (AMERICAN TELEPHONE & TELEGRAPH)<br>* page 6, line 29 - page 8, line 5 * * | 1,2,4-16 | C 23 C 16/18 |
| X | PATENT ABSTRACTS OF JAPAN vol. 14, no. 74 13 February 1990<br>& JP-A-1 290 771 ( NIPPON TELEGRAPH & TELEPHONE CORP. ) 22 November 1989<br>* abstract * * | 1,2,4-9 | |
| X | FR-A-1 157 748 (UNION CARBIDE AND CARBON CORP.)<br>* the whole document * * | 1,4-10 | |
| A | DE-A-1 446 272 (UNION CARBIDE CORP.)<br>* the whole document * * | 1-16 | |
| A | CHEMICAL ABSTRACTS, vol. 110, no. 14, 3 April 1989, Columbus, Ohio, US; abstract no. 125995Z, R.D. ROGERS: 'STRUCTURE OF (C5ME5)(C8H8)ZR, AN AROMATIC MIXED SANDWICH COMPLEX...' page 784 ;column 1 ;<br>* abstract * * | 1,2 | **RECHERCHIERTE SACHGEBIETE (Int. Cl.5)** |
| A | CHEMICAL ABSTRACTS, vol. 105, no. 23, 8 December 1986, Columbus, Ohio, US; abstract no. 209090K, R.D. ROGERS: 'THE FORMATION, CRYSTAL AND MOLECULAR STRUCTURE OF ...' page 613 ;column 1 ;<br>* abstract * * | 1-3 | C 23 C |
| A | CHEMICAL ABSTRACTS, vol. 105, no. 17, 27 October 1986, Columbus, Ohio, US; abstract no. 153182X, J. BLENKERS ET AL: 'GROUP IV MIXED SANDWICH COMPOUNDS:...' page 706 ;column 1 ;<br>* abstract * *<br>-/- | 1-3 | |

Der vorliegende Recherchenbericht wurde für alle Patentansprüche erstellt

| Recherchenort | Abschlußdatum der Recherche | Prüfer |
|---|---|---|
| Den Haag | 21 Oktober 91 | JOFFREAU P.O. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument

Europäisches Patentamt

# EUROPÄISCHER RECHERCHENBERICHT

Nummer der Anmeldung

**EP 91 11 2230**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | CHEMICAL ABSTRACTS, vol. 78, no. 7, 19 February 1973, Columbus, Ohio, US; abstract no. 43548N, H. LHMKUHL ET AL: 'SYNTHESIS OF CYCLOOCTATETRAENE MAGNESIUM COMPOUNDS AND USE OF MAGNESIUM METAL IN THE PREPARATION OF CYCLOOCTATETRAENE TRANSITION METAL COMPOUNDS' page 501 ;column 1 ; * abstract * * | 1 | |
| | – – – | | |
| A | CHEMICAL ABSTRACTS, vol. 74, no. 5, 1 February 1971, Columbus, Ohio, US; abstract no. 22972Y, H.LEHMKUHL ET AL: 'ELECTROCHEMICAL SYNTHESIS OF CYCLOOCTATETRAENE TITANIUM COMPLEXES' page 326 ;column 1 ; * abstract * * | 1 | |
| | – – – – – | | |
| | | | RECHERCHIERTE SACHGEBIETE (Int. Cl.5) |

Der vorliegende Recherchenbericht wurde für alle Patentansprüche erstellt

| Recherchenort | Abschlußdatum der Recherche | Prüfer |
|---|---|---|
| Den Haag | 21 Oktober 91 | JOFFREAU P.O. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument